# EUROPEAN PATENT APPLICATION

(11) **EP 4 818 661 A1**
(43) Date of publication of application: **07.10.2026**
(21) Application number: 25168183.9
(22) Date of filing: 03.04.2025
(51) Int. Cl.: G01L 9/12, G01L 9/00

(54) **PRESSURE SENSOR DEVICE, PRESSURE SENSOR SYSTEM, AND METHOD FOR MANUFACTURING OF THE PRESSURE SENSOR DEVICE**

(71) Applicant: NXP USA, Inc., Austin, TX 78735 (US)
(72) Inventor: Liu, Lianjun, 5656 AG Eindhoven (NL); Monk, Dave Joseph, 5656 AG Eindhoven (NL)
(74) Representative: Schmütz, Christian Klaus Johannes

(57) **Abstract**

The present disclosure relates to a sensor device comprising a sensor substrate, a sensor capacitor, a first sensor contact element, and a second sensor contact element, wherein the sensor capacitor is arranged on a surface, referred to as the first top surface, of the sensor substrate, wherein the sensor capacitor comprises a first sensor electrode and a second sensor electrode, wherein the second sensor electrode is arranged between the first sensor electrode and the first top surface of the sensor substrate such that a sensor cavity is provided between the two sensor electrodes, wherein both sensor contact elements are arranged on another surface, referred to as the first bottom surface, of the sensor substrate, wherein a first electrical interconnection extends through the sensor substrate from the first sensor electrode to the first sensor contact element, and wherein a second electrical interconnection extends through the sensor substrate from the second sensor electrode to the second sensor contact element.

## Description

### TECHNICAL FIELD

The present disclosure relates to pressure sensor device, a pressure sensor system and a method for manufacturing a pressure sensor device.

### BACKGROUND

Pressure sensors may be used in many different applications. In vehicles, for example, pressure sensors may be used to measure oil pressure, tire pressure or fluid pressure. Pressure sensors may also be used in other technical applications.

Due to the small size and/or attractive manufacturing costs, microelectronic pressure sensors offer many advantages. A microelectronic pressure sensor may be coupled to an integrated circuit (IC), in particular an application-specific integrated circuit (ASIC), wherein the integrated circuit is used to evaluate electrical signals of the pressure sensor. The manufacturing of a microelectronic pressure sensor may have different requirements than the manufacturing of an integrated circuit. In an example, it may be advantageous for the manufacturing of the integrated circuit if very high temperatures are avoided during manufacturing. In an example, high temperatures during manufacturing may be acceptable and/or advantageous for the production of the microelectronic pressure sensor. Different depths in focus may also be relevant for the manufacturing of the integrated circuit and the microelectronic pressure sensor. As an effect, microelectronic pressure sensors and integrated circuits may be manufactured separately. A pressure sensing system may comprise the integrated circuit and a microelectronic pressure sensor, wherein the microelectronic pressure sensor is coupled to the integrated circuit.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

**In** accordance with a first aspect of the present disclosure, a sensor device is provided. The sensor device comprises a sensor substrate, a sensor capacitor, a first sensor contact element, and a second sensor contact element, wherein the sensor capacitor is arranged on a surface, referred to as the first top surface, of the sensor substrate, wherein the sensor capacitor comprises a first sensor electrode and a second sensor electrode, wherein the second sensor electrode is arranged between the first sensor electrode and the first top surface of the sensor substrate such that a sensor cavity is provided between the first and second sensor electrodes, wherein both of the first and second sensor contact elements are arranged on another surface, referred to as the first bottom surface, of the sensor substrate, wherein a first electrical interconnection extends through the sensor substrate from the first sensor electrode to the first sensor contact element, and wherein a second electrical interconnection extends through the sensor substrate from the second sensor electrode to the second sensor contact element.

In one or more embodiments, the second sensor electrode is disposed on the sensor substrate, wherein the first sensor electrode extends as a diaphragm over the second sensor electrode.

In one or more embodiments, the sensor cavity is formed between the first sensor electrode and the sensor substrate, such that the second sensor electrode is arranged in the sensor cavity.

In one or more embodiments, a working gas in the sensor cavity comprises a predefined reference pressure that is less than or equal to a predefined atmospheric pressure.

In one or more embodiments, the first electrical interconnection is electrically isolated from the sensor substrate by a first isolation, and wherein the second electrical interconnection is electrically isolated from the sensor substrate by a second isolation.

In one or more embodiments, the first isolation is a hollow cylindrical first isolation layer and the second isolation is a hollow cylindrical second isolation layer.

In one or more embodiments, the sensor capacitor is electrically isolated from the sensor substrate by a third isolation.

In one or more embodiments, the third isolation is a third isolation layer on the first top surface of the sensor substrate, wherein the sensor capacitor is attached to the sensor substrate via the third isolation layer.

In one or more embodiments, the first, second and third isolations are contiguous.

In accordance with a second aspect of the present disclosure, a sensor system is provided. The sensor system comprises a sensor device according to the first aspect of the present disclosure or to any of the preceding embodiments. The sensor system also comprises a system substrate, and a circuit, wherein the circuit is arranged on a surface, referred to as a second top surface, of the system substrate, wherein the circuit comprises a first circuit contact element and a second circuit contact element, and wherein the first sensor contact element is electrically coupled to the first circuit contact element and the second sensor contact element is electrically coupled to the second circuit contact element such that the first bottom surface of the sensor substrate is arranged opposite the circuit and/or the system substrate.

In one or more embodiments, the circuit is an integrated circuit, IC.

In one or more embodiments, the sensor system comprises an integrated circuit, IC, being arranged on the system substrate, wherein the sensor contact elements are electrically coupled to the IC via the circuit.

In accordance with a third aspect of the present disclosure, a method of manufacturing a sensor device is provided. The method comprising the steps of: (a) removing substrate material of a sensor substrate to create a first channel and a second channel each extending from a sensor substrate surface, referred to as first top surface, toward another sensor substrate surface, referred to as first bottom surface, (b) forming a first isolation layer on an inner surface of the first channel, forming a second isolation layer on an inner surface of the second channel, and forming a third isolation layer on the first top surface of the sensor substrate, (c) forming a first electrical interconnection that extends through the third isolation layer and along the first channel, and forming a second electrical interconnection that extends through the third isolation layer and along the second channel, (d) forming or depositing a sensor capacitor on the third isolation layer such that a first sensor electrode of the sensor capacitor is electrically connected only to the first electrical interconnection and a second sensor electrode of the sensor capacitor is electrically connected only to the second electrical interconnection, the second sensor electrode being arranged between the first sensor electrode and the third isolation layer, such that a sensor cavity is provided between the first sensor electrode and the second sensor electrode, and (f) forming a first sensor contact element on the first bottom surface of the sensor substrate such that the first sensor contact element is electrically connected to the first electrical interconnection, and forming a second sensor contact element on the first bottom surface of the sensor substrate such that the second sensor contact element is electrically connected to the second electrical interconnection.

In one or more embodiments, the first and second channels are each formed as a blind hole or a through hole in step (a), wherein the first isolation layer formed on the inner surface of the first channel in step (b) forms a first sub-channel, wherein the second isolation layer formed on the inner surface of the second channel in step (b) forms a second sub-channel, wherein the first electrical interconnection in step (c) is formed by filling the first sub-channel with electrically conductive material, wherein the second electrical interconnection in step (c) is formed by filling the second sub-channel with electrically conductive material, and wherein substrate material is removed from the first bottom surface of the sensor substrate in step (c) such that the first and second isolation layers are exposed.

In one or more embodiments, the first and second channels are each created as a hollow cylindrical channels in step (a), wherein the substrate material removed for the first channel in step (a) is replaced by the first isolation layer in step (b), wherein the substrate material removed for the second channel in step (a) is replaced by the second isolation layer in step (b), and wherein substrate material on the first bottom surface of the sensor substrate is removed in step (c) such that the first and second isolation layers are exposed, wherein the substrate material encased by the first isolation layer forms the first electrical interconnection and wherein the substrate material encased by the second isolation layer forms the second electrical interconnection.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figure 1 shows a simplified block diagram of a sensor device.
Figure 2 shows a simplified block diagram of a sensor system
Figures 3 to 8 schematically illustrate several manufacturing steps of an example of the sensor device.
Figures 9 to 14 schematically illustrate several manufacturing steps of another example of the sensor device.
Figure 15 shows a simplified flow chart of an example of the method.
Figure 16 shows a simplified flow chart of another example of the method.

### DESCRIPTION OF EMBODIMENTS

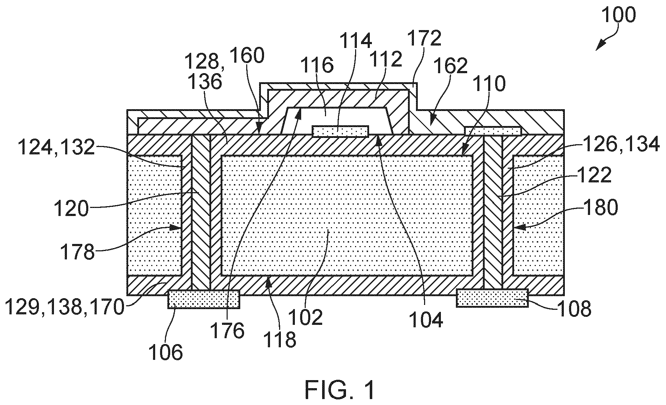

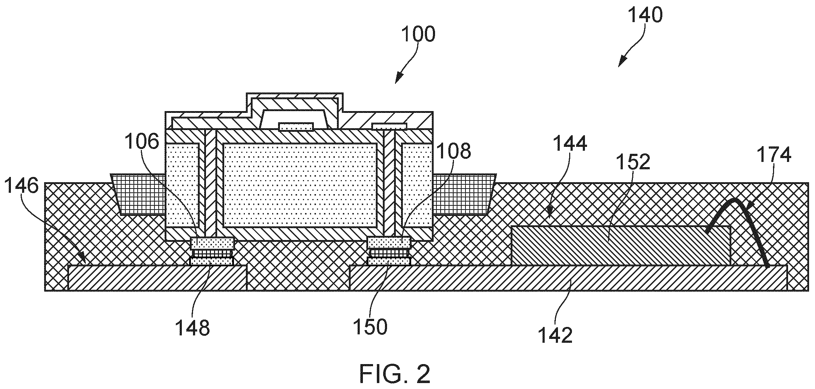

A pressure sensor 100 may be used for a system 140 for measuring pressure. The pressure sensor 100 may also be referred to as sensor device 100. Figure 1 schematically shows an example of a sensor device 100. Figure 2 schematically shows an example of a system 140 comprising a sensor device 100. The following explanations in connection with Figure 1 may also apply analogously to Figure 2, and vice versa. It should be noted that in an example, the sensor device 100 may be configured as a separate component. If reference is made to the sensor device 100 of the system 140 in the following, the associated explanations should be understood in an analogous manner for a sensor device 100 that is configured as a separate sensor device 100 (as shown for example in Figure 1) and/or that is configured as a sensor device 100 independent of the system 140.

In the example from Figure 2, the sensor device 100 may be electrically coupled to the circuit 144 of the system 140. The circuit 144 may comprise an integrated circuit (IC) 152. In one or more embodiments, the integrated circuit 153 is an application-specific integrated circuit. For the electrical coupling, electrical connecting lines may extend from the sensor device 100 to the integrated circuit 152.

Bond wires (not shown) are often used as electrical connecting lines in the prior art. In order to protect such bond wires from external influences, the bond wires are often embedded in a soft gel material. The gel material may extend at least between the sensor device 100 and the integrated circuit 144. The use of bond wires to establish an electrical coupling between the sensor device 100 and the integrated circuit 144 of a pressure sensing system 140 may comprise several disadvantages. One possible disadvantage may be the soft material property of the gel, which allows for some mechanical mobility of the bond wires. This mobility may limit the lifetime of the system 140. Embedding the bond wires in the gel is costly. Gel can be an expensive material in a bill-of-materials. Further, some gel materials may not fully impervious to chemical diffusion resulting in a potential non ideal passivation. For example for applications like tire pressure monitoring systems (TPMS), gel may add weight to the pressure sensor system, so, when in the centrifuge of the tire, it can create an acceleration-induced output, which needs to be considered and/or compensated. Embedding the bond wires in the gel may introduce parasitic capacitances between the bond wires and/or parasitic capacitances between a bond wire and another part of the system 140 and/or the environment. The parasitic capacitances may differ from one another in a variety of systems 140, so that the parasitic capacitances may be subject to random deviation. The random deviations of the parasitic capacitances may have a negative influence on the measurement accuracy of the pressure via the system 140. To reduce the effect of random deviation, the parasitic capacitance may require further attention to be trimmed out during manufacturing. However, the parasitic capacitance could change during the lifetime in the field which may introduce an error. The production of electrical connections between the sensor device 100 and the integrated circuit 144 via bond wires may result in comparatively high production costs. To prevent corrosion of the bond wires, special process steps must often be performed to apply the gel. These special process steps can also account for a corresponding share of the costs of manufacturing the system 140. Furthermore, the use of bond wires may take up a certain amount of the installation space of the system 140.

The following describes a sensor device 100 that overcomes the disadvantages described above. Figure 1 schematically shows an example of the sensor device 100.

The sensor device 100 comprises a substrate 102, also referred to as a sensor substrate 102. The sensor substrate 102 may be configured as a silicon substrate. In addition, the sensor device 100 comprises a capacitor 104, also referred to as a sensor capacitor 104.

The sensor capacitor 104 is disposed on a top surface 110 of the sensor substrate 102. The top surface 110 of the sensor substrate 102 may be referred to as a first top surface 110 of the sensor substrate 102. In one embodiment, the sensor capacitor 104 may be attached directly to the first top surface 110, wherein this embodiment is not shown in Figure 1. In a further embodiment, the sensor capacitor 104 may be attached to the first top surface 110 of the sensor substrate 102 via a further layer, which is in particular formed by a third isolation 128. In an example, the third isolation 128 may form the only layer disposed between the first top surface 110 of the sensor substrate 102 and the sensor capacitor 104.

In an example, the third isolation 128 may be configured as an isolation layer 136 on at least a portion of the first top surface 110 of the sensor substrate 102. The isolation layer 136 may also be referred to as the third isolation layer 136. The third isolation 128 may be configured as an oxidation layer on the first top surface 110 of the sensor substrate 102. The third isolation 128 may be formed, for example, from silicon dioxide. The third isolation 128 may be configured to be electrically isolating.

The sensor capacitor 104 may comprise of two electrodes 112, 114, which may also be referred to as a first sensor electrode 112 and a second sensor electrode 114. In an example, each of the two sensor electrodes 112, 114 is configured as an electrode made of polycrystalline silicon, also referred to as polysilicon. The two sensor electrodes 112, 114 may be arranged at a predefined distance from each other, which is greater than zero. The predefined distance between the two sensor electrodes 112, 114 may be present if a predefined ambient pressure, in particular predefined atmospheric pressure in the environment, acts on the first sensor electrode 112 from the outside. In an example, the second sensor electrode 114 may be arranged parallel to a portion of the first sensor electrode 112. The sensor capacitor 104 may comprise a predefined capacitance, also referred to as a reference capacitance, when the predefined distance exists between the two sensor electrodes 112, 114. If the ambient pressure changes, there may also be a change in the distance between the two sensor electrodes 112, 114 in response to the change in ambient pressure. The change in distance may be functionally related to the change in ambient pressure. The distance can thus represent the ambient pressure. Furthermore, since the distance may be functionally related to the capacitance of the sensor capacitor 104, the capacitance of the sensor capacitor 104 may be representative of the ambient pressure. In an example of the system 140, the circuit 144 may be (at least indirectly) coupled to the sensor capacitor 104. The circuit, in particular the IC 152 of the circuit 144, may be configured to detect the capacitance of the sensor capacitor 104. The circuit, in particular the IC 152 of the circuit 144, may be configured to determine a pressure acting on the outside surface of the first electrode 112 of the sensor capacitor 104 based on the detected capacitance, in particular based on a detected change in the capacitance.

The second sensor electrode 114 is arranged between the first sensor electrode 112 and the first top side 110 of the sensor substrate 102 resulting in a cavity 116 between the two sensor electrodes 112, 114. The cavity 116 may also be referred to as the sensor cavity 116. The sensor cavity 116 may prevent direct electrical contact between the two sensor electrodes 112, 114. In particular, there is no galvanic electrical contact between the two sensor electrodes 112, 114. In one embodiment, the second sensor electrode 114 may be directly attached to the first top surface 110, wherein this embodiment is not shown in Figure 1. In a further embodiment, the second sensor electrode 114 may be attached to the first top surface 110 of the sensor substrate 102 via the third isolation 128. In an example, the second sensor electrode 114 may be arranged between the first sensor electrode 112 and the third isolation 128 resulting in the sensor cavity 116 between the first sensor electrodes 112 and the third isolation 128. The second sensor electrode 114 may be electrically isolated from the first sensor electrode 112 by the sensor cavity 116.

In an example, the sensor cavity 116 may be hermetically sealed. In one embodiment, the hermetically sealed sensor cavity 116 may be formed by the first sensor electrode 112 and the third isolation 128. In an alternative embodiment, not shown in Figure 1, the hermetically sealed sensor cavity 116 may be formed by the first sensor electrode 112 and the sensor substrate 102. A pressure in the sensor cavity 116 may be at a predefined reference pressure. The reference pressure may be equal to atmospheric pressure or less than atmospheric pressure. The reference pressure may also be referred to as a vacuum. In an example, the sensor cavity 116 is completely filled by a predefined gas, which is also referred to as a working gas, in particular except for a space occupied by the second sensor electrode 114. The working gas may be compressible. The working gas may be, for example, air or another gas, in particular another gas mixture. In an example, the working gas may cause a reaction force on the two sensor electrodes 112, 114 in response to compression of the working gas. As an effect, the capacitance of the sensor capacitor 104 may functionally depend on the ambient pressure.

The distance between the facing surfaces of the two sensor electrodes 112, 114 may be a distance that is particularly within a predefined range of values. In an example, the predefined range of values represents a possible variation of the distance, in particular depending to an external pressure which may act directly or indirectly on a surface of the first sensor electrode 112 facing away from the second sensor electrode 114. An electrical capacitance of the sensor capacitor 104 and/or the electrical capacitance between the two sensor electrodes 112, 114 may be dependent on the distance.

In an example, a mechanical force, for example caused by an air pressure or fluid pressure acting directly or indirectly on the first sensor electrode 112 from the outside, may be applied to the first sensor electrode 112, so that the mechanical force reduces the distance between the two sensor electrodes 112, 114 by compressing the working gas. As a result, the electrical capacitance of the sensor capacitor 104 changes. The change in electrical capacitance and/or the absolute value of the electrical capacitance may represent the mechanical force and/or the external pressure, in particular the external air pressure or the external fluid pressure.

The sensor device 100 comprises two contact elements 106, 108, which may also be referred to as a first sensor contact element 106 and a second sensor contact element 108. The two sensor contact elements 106, 108 are arranged on a further outside surface 118 of the sensor substrate 102. The further outside surface 118 may also be referred to as the first bottom surface 118 of the sensor substrate 102. The first top surface 110 and the first bottom surface 118 may be outside surfaces 110, 118 of the sensor substrate 102 that face away from each other.

In one embodiment, the first sensor contact element 106 and the second sensor contact element 108 may each be attached directly to the first bottom surface 118, wherein this embodiment is not shown in Figure 1. In a further embodiment, the first sensor contact element 106 and the second sensor contact element 108 may be attached to the first bottom surface 118 of the sensor substrate 102 via a further layer 138, which is in particular formed by a fourth isolation 129. The layer 138 may also be referred to as a fourth isolation layer 138. In an example, the isolation layer 138 may be the only layer disposed between the first bottom surface 118 of the sensor substrate 102 and the two contact elements 106, 108. In an example, the isolation layer 138 may be formed on at least a portion of the first bottom surface 118 of the sensor substrate 102. The isolation layer 138 may be configured as an oxidation layer on the first bottom surface 118 of the sensor substrate 102. The fourth isolation 129 or the isolation layer 138 may be formed, for example, from silicon dioxide. The fourth isolation 129 or the isolation layer 138 may be configured to be electrically isolated. The two sensor contact elements 106, 108 may each be configured as metal sensor contact elements 106, 108. The two sensor contact elements 106, 108 may each be configured as a metal pad. In one or more embodiments, the two sensor contact elements 106, 108 may be made of another material than metal. In an example, the two sensor contact elements 106, 108 do not need to overlap with the interconnections 120, 122, respectively.

The sensor device 100 comprises a first electrical interconnection 120 and a second electrical interconnection 122. The first electrical interconnection 120 extends through the sensor substrate 102 from the first sensor electrode 112 to the first sensor contact element 106. The second electrical interconnection 122 extends through the sensor substrate 102 from the second sensor electrode 114 to the second sensor contact element 108. Each of the two electrical interconnections 120, 122 may be configured as an electrically conductive line and/or as an electrically conductive conduit. Each of the two electrical interconnections 120, 122 may be rod-shaped. As an effect, each of the two electrical interconnections 120, 122 may extend linearly through the sensor substrate 102. Each of the two electrical interconnections 120, 122 may be surrounded laterally by the sensor substrate 102. As an effect, each of the two electrical interconnections 120, 122 may be protected from external influences via the sensor substrate 102. Each of the two electrical interconnections 120, 122 may be formed from polysilicon material. The first electrical interconnection 120 may be configured to establish an electrically conductive connection between the first contact element 106 and the first sensor electrode 112. The second electrical interconnection 122 may be configured to establish an electrically conductive connection between the second contact element 108 and the second sensor electrode 114.

The two sensor contact elements 106, 108 on the first bottom surface 118 offer the possibility that the sensor device 100 can be connected to further electrical components in a very space-saving way. In an example, the sensor device 100 may simultaneously fulfill two functions via the two sensor contact elements 106, 108: firstly, an electrical connection to other contact elements may be established via the two sensor contact elements 106, 108, and secondly, the two sensor contact elements 106, 108 may be used to mechanically attach the sensor device 100 to the other electrical component.

Figure 2 schematically illustrates an example of a system 140. The system 140 is also referred to as a sensor system 140.

The sensor system 140 comprises the sensor device 100, a circuit 144, and a substrate 142. The substrate 142 is not the sensor substrate 102 of the sensor device 100, but the substrate 142 is a further substrate 142. The substrate 142 is also referred to as the system substrate 142. The circuit 144 may comprise a plurality of passive and/or active electrical components. The components may be interconnected and/or coupled to one another in a network. In an example, the circuit 144 (or a part thereof) may be configured as an integrated circuit, IC. The circuit 144 may be mounted on the system substrate 142.

In an example, the circuit 144 comprises two contact elements 148, 150, also referred to as a first circuit contact element 148 and a second circuit contact element 150. The circuit 144 may be arranged on an outside surface 146 of the system substrate 142. In particular, the two circuit contact elements 148, 150 may be arranged on the outside surface 146 of the system substrate 142. The outside surface 146 of the system substrate 142 is also referred to as the second top surface 146. In an example, the circuit 144 may comprise the two circuit contact elements 148, 150 and an integrated circuit 152, wherein the circuit 144 may further comprise conductor lines (not shown in Figure 2) that electrically connect the two circuit contact elements 148, 150 to the integrated circuit 152. The circuit contact elements 148, 150, the (not shown) conductive lines and the system substrate 142 may each form part of a printed circuit board. The circuit contact elements 148, 150 may be coupled to the integrated circuit 152 via the printed circuit board.

The sensor contact elements 106, 108 on the first bottom surface 118 of the sensor substrate 102 enable a space-saving attachment to the system substrate 142 and at the same time an electrical coupling to the circuit contact elements 148, 150. In the example in Figure 2, the first sensor contact element 106 is electrically and mechanically coupled to the first circuit contact element 148, wherein the second sensor contact element 108 is electrically and mechanically coupled to the second circuit contact element 150.

In one or more embodiment, for coupling between the sensor device 100 and the circuit 144, the sensor contact elements 106, 108 and the circuit contact elements 148, 150 are arranged to be overlapping, respectively.

The sensor device 100 comprises a first electrical interconnection 120 extending through the sensor substrate 102 from the first sensor electrode 112 to the first sensor contact element 106. The sensor device further comprises a second electrical interconnection 122 extending through the sensor substrate 102 from the second sensor electrode 114 to the second sensor contact element 108. With both electrical interconnections 120, 122 extending through the sensor substrate 102 to the first bottom surface 118 of the sensor substrate 102, where they may be each connected to an associated sensor contact element 106, 108, outside bond wires between sensor electrodes 112, 114 and the electrical circuit 144 may be prevented. In the absence of such outside bond wires, gel for stabilizing the absent bond wires may also be prevented. By eliminating the bond wires and associated gel to stabilize the non-existent bond wires, the effort required to electrically couple the sensor device 100 to the circuit 144 of the sensor system 140 can be significantly reduced. The reduced effort may reduce associated costs.

By routing the electrical interconnections 120, 122 through the sensor substrate 102, there is a precisely predictable parasitic capacitance between the electrical interconnections 120, 122 and/or a (further) precisely predictable parasitic capacitance between each of the two electrical interconnections 120, 122 and the sensor substrate 102. It is to be noted that the electrical interconnections 120, 122, in contrast to bond-wires in gel, also allow for a constant parasitic capacity over a longer period of time. For the two electrical interconnections 120, 122, the parasitic capacitance can be determined and/or defined much more precisely in advance than for the non-existing bond wires (between the sensor electrodes 112, 114 and the circuit 144). The more precisely the parasitic capacitances can be determined and/or defined in advance, the more precisely these parasitic capacitances may be taken into account in the evaluation of the total capacitance that can be measured via the two sensor contact elements 106, 108 or the two circuit contact elements 148, 150. In an example, the integrated circuit 152 may be configured to subtract a pre-determined and/or pre-defined parasitic capacitance of the sensor device 100, particularly existing between the two sensor contact elements 106, 108, from a total capacitance measured between the two sensor contact elements 106, 108 or the two circuit contact elements 148, 150, so that the resulting net capacitance corresponds to an actual electrical capacitance of the sensor capacitor 104. As an effect, the two electrical interconnections 120, 122 enable the possibility to precisely take into account parasitic effects and, on the basis of this consideration, to ensure a more accurate measurement of the electrical capacitance of the sensor capacitor 104. As a further effect, the two electrical interconnections 120, 122 not only allow a more accurate measurement of the electrical capacitance of the sensor capacitor 104, but also a more accurate detection of a pressure, in particular an ambient pressure, via the sensor device 100.

If the ambient pressure changes outside the sensor device 100, the two electrical interconnections 120, 122 within the sensor substrate 102 are protected from the influence of the pressure changes. As an effect, the sensor device 100 comprising said electrical interconnections 120, 122 is capable of enabling precise pressure measurements even with changing ambient pressures. As a further effect, the electrical interconnections 120, 122 are protected from corrosion by the sensor substrate 102. The two effects prevent the parasitic capacitances of the sensor device 100 from changing in an unpredictable and/or random manner. As an additional effect, the protection provided by the sensor substrate 102 also ensures a repeated precise pressure detection even under changing ambient conditions.

A further advantage of the sensor device 100 is indicated in Figure 2, in which the use of the sensor device 100 for a sensor system 140 is shown schematically. The sensor capacitor 104 and the two sensor contact elements 106, 108 are arranged on outside surfaces 110, 118 facing away from each other (i.e. on the first top surface 110 and on the first bottom surface 118), so that the sensor capacitor 104 enables precise measurement of a pressure and the two sensor contact elements 106, 108 enable a simple and robust electrical/mechanical connection to the circuit 144 of the sensor system 140. The arrangement on the opposing outside surfaces 110, 118 may be comprised in a very compact design of the sensor device 100. Due to the compact design, only a very small space of the sensor system 140 is used. The compact design also allows for a very short length of the two electrical interconnections 120, 122, so that at most only a small influence of parasitic capacities is to be expected.

In an example, the first sensor contact element 106 and the second sensor contact element 108 may each comprise a contact point or multiple contact points. If a sensor contact element 106, 108 comprises multiple contact points, then the associated contact points may be electrically coupled to each other, in particular by a star-shaped coupling. The multiple contact points of a contact element 106, 108 may provide multiple parallel electrical couplings to a corresponding circuit contact element 148, 150. In an example, the first sensor contact element 106 may comprise multiple contact points. The first circuit contact element 148 may also comprise multiple contact points. In an example, the contact points of the first sensor contact element 106 may be parallel to the contact points of the first circuit contact element 148, such that opposing contact points are electrically coupled to enable a plurality of parallel electrical couplings between the first sensor contact element 106 and the first circuit contact element 148. In an example, the first circuit contact element 148 and the second circuit contact element 150 may each comprise one or more contact points. In the case that both the second sensor contact element 108 and the second circuit contact element 150 each comprise a plurality of contact points, a plurality of electrical couplings arranged in parallel between the second sensor contact element 108 and the second circuit contact element 150 may be similarly enabled.

In an example, the first sensor electrode 112 may be formed from a conductive silicon material, in particular from polysilicon. The first sensor electrode 112 may comprise an edge section running around the sensor cavity 116 in a ring shape. Another section of the first sensor electrode 112, which extends over the sensor cavity 116 and/or the second sensor electrode 114, may be concavely shaped. In an example, the first sensor electrode 112 may be in the form of a membrane, in particular a concavely shaped membrane. In the example, an associated concave surface 176 of the first sensor electrode 112 may be arranged opposite the second sensor electrode 114. The sensor cavity 116 may be between the concave surface 176 of the first sensor electrode 112 and the second sensor electrode 114. In an example, the first sensor electrode 112 may also be referred to as a diaphragm. The first sensor electrode 112 may extend as a diaphragm over the second sensor electrode 114, in particular such that the sensor cavity 116 is formed between the two sensor electrodes 112, 114. In one or more embodiments, the diaphragm refers to a thin sheet or a membrane of material that is deformable through an application of pressure. As an effect, the first sensor electrode 112 may be configured to be elastically deformable in response to an external pressure applied to the first sensor electrode 112.

In an example, the second sensor electrode 114 may be formed of a conductive silicon material, such as polysilicon material. The second sensor electrode 114 may be deposited directly or indirectly on the sensor substrate 102. In the example of Figure 1, the second sensor electrode 114 is indirectly deposited on the sensor substrate 102. The second sensor electrode 114 may be deposited on the third isolation layer 136 such that the second sensor electrode 114 is attached to the sensor substrate 102 via the third isolation layer 136. Deposition of the second sensor electrode 114 enables efficient, low-cost and compact fabrication of the sensor device 100.

In an example, the first sensor electrode 112 may comprise a concave shaped portion forming the concave surface 176 of the first sensor electrode 112. The interior formed under the concave surface 176 may form the sensor cavity 116. The second sensor electrode 114 may be arranged in the sensor cavity 116. There may be a predefined distance between the first sensor electrode 112 and the second sensor electrode 114, in particular if a predefined pressure acts on the first sensor electrode 112 from the outside. The distance may refer to a mean distance or a minimum distance between the two sensor electrodes 112, 114. The predefined pressure may be a predefined atmospheric pressure. As indicated above, the distance between the two sensor electrodes 112, 114 may change depending on the pressure acting on the first sensor electrode 112 from the outside. The concave shaped portion of the first sensor electrode 112 enables a precise pressure detection.

In an example, a peripheral edge portion of the first sensor electrode 112 may be deposited on and/or attached to the third isolation layer 136. The peripheral edge portion of the first sensor electrode 112 may be fluid-tight connected to the third isolation layer 136 so that the sensor cavity 116 is hermetically sealed. The second sensor electrode 114 may be deposited on the third isolation layer 136 such that the second sensor electrode 114 is disposed in the sensor cavity 116. The arrangement of the two sensor electrodes 112, 114 forming the sensor cavity 116 allows for a compact design of the sensor device 100.

In an example, the sensor substrate 102 comprises a first channel 178 and a second channel 180. Each of the two channels 178, 180 may extend from the first top surface 110 to the first bottom surface 118. Each of the two channels 178, 180 may be a straight channel.

In an example, the first electrical interconnection 120 may extend through the first channel 178 from the first sensor electrode 112 to the first sensor contact element 106. A first channel inner wall of the first channel 178 may be formed by the sensor substrate 102. In an example, the first electrical interconnection 120 does not have direct and/or galvanic contact with the first channel inner wall of the first channel 178. In an example, the first electrical interconnection 120 may be electrically isolated from the sensor substrate 102 by a first isolation 124. The first isolation 124 may comprise silicon oxide or be formed from silicon oxide. In an example, the first isolation 124 may extend circular around the first electrical interconnection 120, in particular such that the first isolation 124 has a hollow cylindrical shape. The first isolation 124 may form a first isolation layer 132. The first isolation layer 132 may be disposed between a lateral surface of the first electrical interconnection 120 and the first channel inner wall of the first channel 178. The first isolation layer 132 may be configured to electrically isolate the first electrical interconnection 120 from the sensor substrate 102. The first electrical interconnection 120 and/or the first isolation layer 132 may be coaxial with a longitudinal axis of the first channel 178. The first isolation 124 may have a passivating effect. The first isolation 124 may further protect the first electrical interconnection 120 from external influences. In an example, the first isolation 124 may prevent oxidation of the first electrical interconnection 120.

In an example, the second electrical interconnection 122 may extend through the second channel 180 from the second sensor electrode 114 to the second sensor contact element 108. A second channel inner wall of the second channel 180 may be formed by the sensor substrate 102. In an example, the second electrical interconnection 122 does not have direct and/or galvanic contact with the second channel inner wall of the second channel 180. In an example, the second electrical interconnection 122 may be isolated from the sensor substrate 102 by a second isolation 126. The second isolation 126 may comprise silicon oxide or be formed of silicon oxide. In an example, the second isolation 126 may extend circular around the second electrical interconnection 122, in particular such that the second isolation 126 has a hollow cylindrical shape. The second isolation 126 may form a second isolation layer 134. The second isolation layer 134 may be disposed between a lateral surface of the second electrical interconnection 122 and the second channel inner wall of the second channel 180. The second isolation layer 134 may be configured to electrically isolate the second electrical interconnection 122 from the sensor substrate 102. The second electrical interconnection 122 and/or the second isolation layer 134 may be coaxial with a longitudinal axis of the second channel 180. The second isolation 126 may have a passivating effect. The second isolation 126 may further protect the second electrical interconnection 122 from external influences. In an example, the second isolation 126 may prevent oxidation of the second electrical interconnection 122.

In an example, the first isolation 124, the second isolation 126, and the third isolation 128 may be configured as contiguous and/or integral isolations 124, 126, 128. In a further example, the first isolation 124, the second isolation 126, the third isolation 128, and the fourth isolation 129 may be configured as contiguous and/or integral isolations 124, 126, 128, 129. The isolations 124, 126, 128, 129 may be used to achieve a fluid-tight encapsulation of the two electrical interconnections 120, 122. The encapsulation may provide a particularly good protection of the two electrical interconnections 120, 122 against external influences. The good protective effect may effectively prevent accidental deviations of the parasitic capacitances. As an effect, a particularly precise pressure detection may be achieved via the sensor device 100.

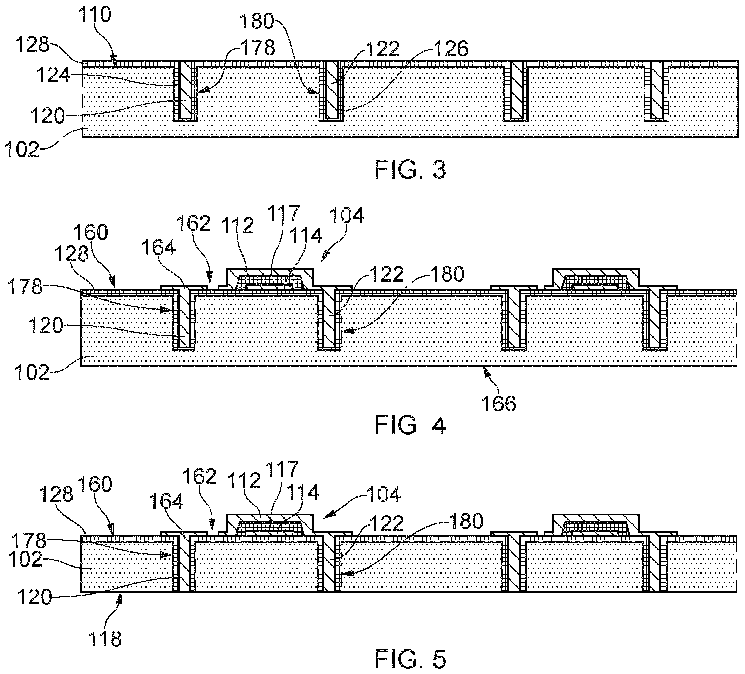

An example of a process for manufacturing a first embodiment of the sensor device 100 is explained below in conjunction with Figures 3-8.

Figure 3 schematically shows a sensor substrate 102 of a sensor device 100. In an example, based on the process according to Figures 3-8, a plurality of sensor devices 100 may be manufactured in parallel. To also schematically show this parallel manufacturing possibility in Figures 3-8, the sensor substrate 102 may form part of a wafer. The waver may comprise a plurality of sensor substrates 102. The following explanations refer to a single sensor device 100. The explanations may apply to each sensor device 100, in particular if a plurality of sensor devices 100 are manufactured in parallel.

In an example, substrate material of the sensor substrate 102 may be removed to create the first channel 178 and the second channel 180. The substrate material may be removed such that each channel 178, 180 extends from the first top surface 110 of the sensor substrate 102 into the sensor substrate 102. Each of the two channels 178, 180 may be configured as a blind hole and/or a full cylindrical channel. In an example, each channel 178, 180 may comprise a continuous circular cross-section. In an example, the substrate material may be removed by etching. Each of the two channels 178, 180 may extend perpendicular to the first top surface 110 into the sensor substrate 102.

An oxide material may be deposited into the first channel 178, so that the first channel inner surface of the first channel 178 is covered with the oxide material. An oxide material may also be deposited in the second channel 180 so that the second channel inner surface of the second channel 180 is covered with the oxide material. Furthermore, an oxide material may be deposited on the first top surface 110 of the sensor substrate 102. The oxide material in the first channel 178 may form a first isolation 124. The oxide material in the second channel 180 may form a second isolation 126. The oxide material deposited on the first top surface 110 may form a third isolation 128.

In an example, the first channel 178 is covered by the oxide material only on the associated channel inner surface, so that a pin-shaped first inner channel is formed. A conductive semiconductor material, such as polysilicon that has been doped to become electrically conductive, may be deposited into the first inner channel so that the first inner channel is completely filled by the conductive semiconductor material. The conductive semiconductor material filling the first inner channel may form the first electrical interconnection 120 of the sensor device 100.

In an example, the second channel 180 is covered by the oxide material only on the associated channel inner surface, so that a pin-shaped second inner channel is formed. A conductive semiconductor material, such as polysilicon that has been doped to become electrically conductive, may be deposited into the second inner channel so that the second inner channel is completely filled by the conductive semiconductor material. The conductive semiconductor material filling the second inner channel may form the second electrical interconnection 122 of the sensor device 100. Each of the first and second electrical connection 120, 122 may have a resistivity of less than 500 ohm, less than the 200 ohm or less than 100 ohm.

In an example, the second sensor electrode 114 may be deposited on the third isolation 128. The second sensor electrode 114 is schematically shown in Figure 4. The second sensor electrode 114 may be formed of a conductive semiconductor material, in particular polysilicon. The conductive semiconductor material of the second sensor electrode 114 is deposited on the third isolation 128 such that the second sensor electrode 114 is electrically coupled to the second electrical interconnection 122.

A semiconductor material, also referred to as a sacrificial material 117, may be deposited over a region of the third isolation 128 that is located between the first electrical interconnection 120 and the second electrical interconnection 122. The sacrificial material 117 may be deposited such that the sacrificial material 117 completely covers the second sensor electrode 114. In an example, the sacrificial material 117 may be deposited such that the sacrificial material 117 forms a convex surface facing away from the third isolation 128. In an example, the sacrificial material 117 may be formed by a phosphorus-doped silicon oxide.

In an example, the first sensor electrode 112 may be deposited on the third isolation 128 and the sacrificial material 117. The first sensor electrode 112 may be formed from a conductive semiconductor material, in particular polysilicon material. The conductive semiconductor material of the first sensor electrode 112 is deposited in particular on the third isolation 128 and the sacrificial material 117 such that the first sensor electrode 112 is electrically connected to the first electrical interconnection 120 and that the first sensor electrode 112 has no galvanic electrical contact to the second sensor electrode 114. In addition, the conductive semiconductor material of the first sensor electrode 112 may be deposited on the third isolation 128 and the sacrificial material 117 such that the convex surface of the sacrificial material 117 is completely covered and that a peripheral edge around the sacrificial material 117 is deposited on the third isolation 128, in particular such that the first sensor electrode 114 comprises the form of a membrane, in particular as a diaphragm. The inner surface of the membrane, in particular of the diaphragm, which is opposite to the second electrode 114, may be concave.

Substrate material may be removed at a bottom surface 166 of the sensor substrate 102. An example in which substrate material at the bottom surface 166 of the sensor substrate 102 is removed is shown in Figure 5. The substrate material may be removed chemically and/or mechanically. In an example, a predefined layer and/or thickness of substrate material of the sensor substrate 102 may be removed at the bottom surface 166. Removal of the substrate material at the bottom surface 166 of the sensor substrate 102 creates the first bottom surface 118 of the sensor substrate 102.

In an example, the substrate material at the bottom surface 166 of the sensor substrate 102 may be removed so that each of two channels 178, 180 extends from the first top surface 110 to the first bottom surface 118. As an effect, each of the two electrical interconnections 120, 122 extends through the sensor substrate 102 to the first bottom surface 118. The free ends of the first and second interconnections 120, 122 exposed at the first bottom surface 118 are shown schematically in an example in Figure 5.

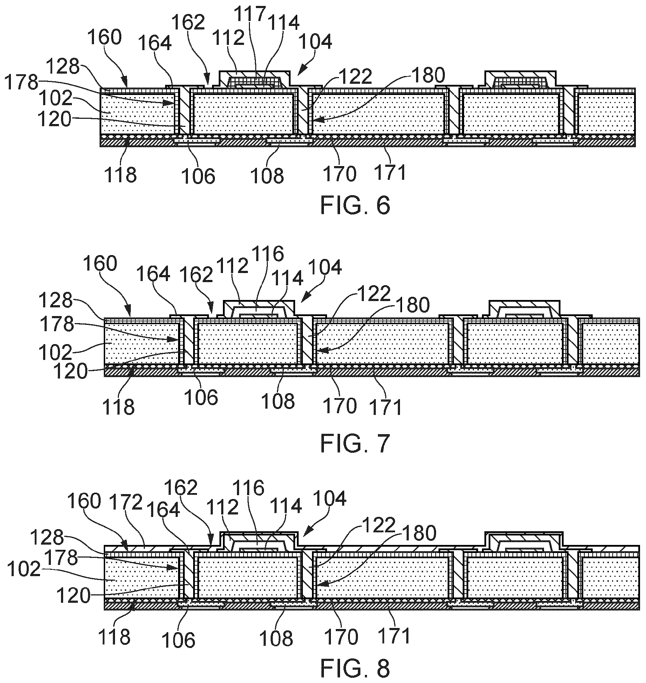

A first sensor contact element 106 may be attached to the free end of the first electrical interconnection 120, so that an electrical connection is created between the first sensor contact element 106 and the first electrical interconnection 120. A second sensor contact element 108 may be attached to the free end of the second electrical interconnection 122, so that an electrical connection is created between the second sensor contact element 108 and the second electrical interconnection 122. In Figure 6, both sensor contact elements 106, 108 are shown schematically. The two sensor contact elements 106, 108 may also be attached to the first bottom surface 118 of the sensor substrate 102 via a fourth isolation layer 170. The fourth isolation layer 170 may be produced by depositing an oxide material on the second bottom surface 118 of the sensor substrate 102.

After the fourth isolation layer 170 has been created, a further layer 171 may be created, in particular deposited, on the fourth isolation layer 170. The further layer 171 may also be referred to as a passivation layer 171. The passivation layer 171 may be deposited such that the two sensor contact elements 106, 108 remain accessible from the outside. The layer 171 may be formed from a silicon oxide or a silicon nitride.

A gap 162 may be created subsequently or during the deposition of the first sensor electrode 112. The gap 162 may be configured such that the gap 162 forms an external access to the sacrificial material 117. Through the gap, the sacrificial material 117 can be removed, in particular etched away. Figure 7 shows an example where the sacrificial material 117 has been removed. The removal, in particular the etching away, of the sacrificial material 117 creates the sensor cavity 116. As an effect, the sacrificial material 117 serves as a placeholder for the sensor cavity 116. Furthermore, the sacrificial material 117 allows for a particularly simple and precise production of a concave shape of the first sensor electrode 112. Furthermore, the sacrificial material 117 may be used to create a precise distance between the first sensor electrode 112 and the second sensor electrode 114.

After the sacrificial material 117 has been removed and/or after the sensor cavity 116 has been created, a further layer 172 may be applied, in particular deposited, on the third isolation 128 and on the outside of the first electrode 112. An example of the layer 172 is schematically shown in Figure 8. Layer 172 may in particular also be deposited over the gap 162, so that gap 162 is closed by layer 172. By closing gap 162, sensor cavity 116 is hermetically sealed. In one or more embodiments, it sensor cavity 116 is fluid-tight. In an example, a predefined ambient pressure may be provided during the closing of the gap 162. The predefined ambient pressure may be less than atmospheric pressure. The predefined ambient pressure mentioned above exists in the sensor cavity 116 after the sensor cavity 116 is hermetically sealed. Thus, by selecting the predefined ambient pressure, the pressure in the hermetically sealed sensor cavity 116 can be precisely set. The layer 172 may also be referred to as a second passivation layer 172. In an example, the layer 172 may be formed from silicon oxide or a silicon nitride.

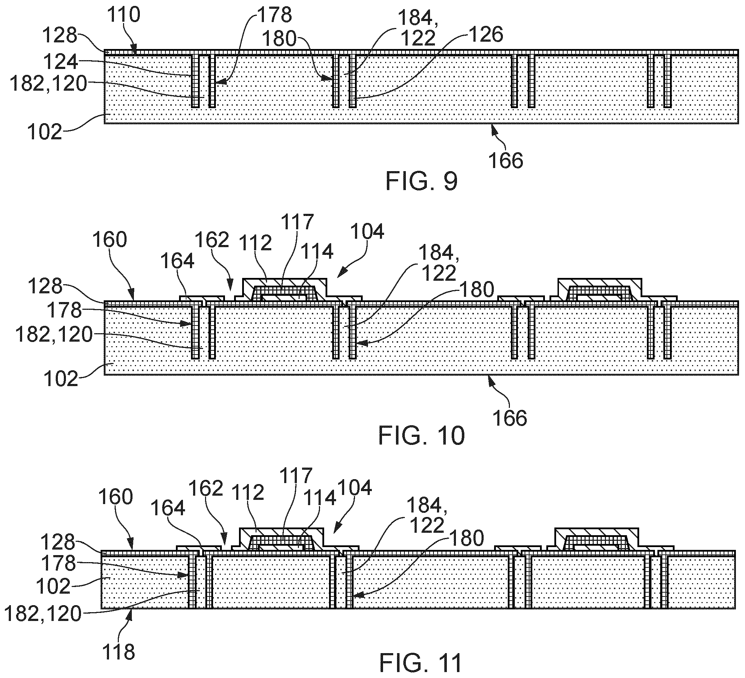

An example of a process for manufacturing a second embodiment of the sensor device 100 is explained below in conjunction with Figures 9-14.

Figure 9 schematically illustrates a sensor substrate 102 of a sensor device 100. In an example, based on the process according to Figures 9-14, a plurality of sensor devices 100 may be manufactured in parallel. In order to also schematically represent this parallel manufacturing possibility in Figures 9-14, the sensor substrate 102 may form part of a wafer. The wafer may comprise a plurality of sensor substrates 102. The following explanations refer to a single sensor device 100. The explanations may apply to each sensor device 100, in particular if several sensor devices 100 are manufactured in parallel.

In an example, substrate material of the sensor substrate 102 may be removed to create the first channel 178 and the second channel 180. For each of the two channels 178, 180, the substrate material may be removed in an annular cross-section such that each of the two channels 178, 180 is configured as a hollow cylindrical channel. The substrate material may also be removed such that each channel 178, 180 extends from the first top surface 110 of the sensor substrate 102 into the sensor substrate 102. The hollow cylindrical shape allows each channel 178, 180 to comprise an annular cross-section. In an example, the substrate material may be removed by etching. Each of the two channels 178, 180 may extend perpendicularly to the first top surface 110 into the sensor substrate 102.

In Figure 9 an example is shown schematically, wherein each of the two channels 178, 180 extends from the first top surface 110 into the sensor substrate 102, but without the two channels 178, 180 extending to the bottom surface 166. As an effect, a pin-shaped body 182, 184 remains for each of the two channels 178, 180. Each of the two pin-shaped bodies 182, 184 is formed from substrate material of the sensor substrate 102. At the lower end, each of the two pin-shaped bodies 182, 184 may still be connected to the sensor substrate 102. In the case of the first channel 178, a first pin-shaped body 182 may be arranged coaxially with the first channel 178. The first channel 178 may annularly surround the first pin-shaped body 182, in particular in a ring shape. The first pin-shaped body 182 is later used to generate the first interconnection 120. In the case of the second channel 180, a second pin-shaped body 184 may be arranged coaxially with the second channel 180. The second channel 180 may surround the second pin-shaped body 184 in a ring shape. The second pin-shaped body 184 is later used to create the second interconnection 122.

An oxide material may be deposited into the first channel 178 so that the first channel 178 is completely filled by the oxide material. In another example, the oxide material may be thermally grown by oxidizing the silicon substrate (102) material. An oxide material may also be deposited in the second channel 180 so that the second channel 180 is completely filled by the oxide material. In another example, the oxide material may be thermally grown by oxidizing the silicon substrate (102) material. Furthermore, an oxide material may be deposited on the first top surface 110 of the sensor substrate 102. The oxide material in the first channel 178 may form the first isolation 124. The oxide material in the second channel 180 may form the second isolation 126. The oxide material deposited on the first top surface 110 may form the third isolation 128.

In an example, the second sensor electrode 114 may be deposited on the third isolation 128. The second sensor electrode 114 is shown schematically in Figure 10. The second sensor electrode 114 may be formed from a conductive semiconductor material, in particular polysilicon material. The conductive semiconductor material of the second sensor electrode 114 is deposited on the third isolation 128 such that the second sensor electrode 114 is electrically coupled to the second electrical interconnection 122.

A semiconductor material, also referred to as sacrificial material 117, may be deposited over a region of the third isolation 128 that is located between the first electrical interconnection 120 and the second electrical interconnection 122. The sacrificial material 117 may be deposited such that the sacrificial material 117 completely covers the second sensor electrode 114. In an example, the sacrificial material 117 may be deposited such that the sacrificial material 117 forms a convex surface facing away from the third isolation 128. In an example, the sacrificial material 117 may be formed by a phosphorus-doped silicon oxide.

In an example, the first sensor electrode 112 may be deposited on the third isolation 128 and the sacrificial material 117. The first sensor electrode 112 may be formed from a conductive semiconductor material, in particular polysilicon material. The conductive semiconductor material of the first sensor electrode 112 is deposited in particular on the third isolation 128 and the sacrificial material 117 such that the first sensor electrode 112 is electrically connected to the first electrical interconnection 120 and that the first sensor electrode 112 has no galvanic electrical contact to the second sensor electrode 114. In addition, the conductive semiconductor material of the first sensor electrode 112 may be deposited on the third isolation 128 and the sacrificial material 117 such that the convex surface of the sacrificial material 117 is completely covered and that a peripheral edge around the sacrificial material 117 is deposited on the third isolation 128, in particular such that the first sensor electrode 114 comprises the form of a membrane, in particular as a diaphragm. The inner surface of the membrane, in particular of the diaphragm, which is opposite to the second electrode 114, may be concave.

Substrate material may be removed at a bottom surface 166 of the sensor substrate 102. An example in which substrate material is removed at the bottom surface 166 of the sensor substrate 102 is shown in Figure 11. The substrate material may be removed chemically and/or mechanically. In an example, a predefined layer and/or thickness of the substrate material of the sensor substrate 102 may be removed at the bottom surface 166. Removing the substrate material at the bottom surface 166 of the sensor substrate 102 creates the first bottom surface 118 of the sensor substrate 102.

In an example, the substrate material at the bottom surface 166 of the sensor substrate 102 may be removed so that each of two channels 178, 180 extends from the first top surface 110 to the first bottom surface 118. As an effect, each of the two pin-shaped bodies 182, 184 extends through the sensor substrate 102 to the first bottom surface 118. The free ends of the two pin-shaped bodies 182, 184 exposed at the first bottom surface 118 are shown schematically in an example in Figure 11. In an example, the first pin-shaped body 182 is attached to the sensor substrate 102 via the first isolation 124. By removing the substrate material at the bottom surface 166 of the sensor substrate 102, the first pin-shaped body 182 no longer comprises a galvanic electrical connection to the sensor substrate 102. As an effect of removing the substrate material at the bottom surface 166 of the sensor substrate 102, the first interconnection 120 is formed from the first pin-shaped body 182. The first interconnection 120 is isolated from the sensor substrate 102 by the first isolation 124. In an example, the second pin-shaped body 184 is attached to the sensor substrate 102 via the second isolation 126. By removing the substrate material at the bottom surface 166 of the sensor substrate 102, the second pin-shaped body 184 no longer comprises a galvanic electrical connection to the sensor substrate 102. As an effect of removing the substrate material at the bottom surface 166 of the sensor substrate 102, the second interconnection 122 is formed from the second pin-shaped body 184. The second interconnection 122 is isolated from the sensor substrate 102 by the second isolation 126.

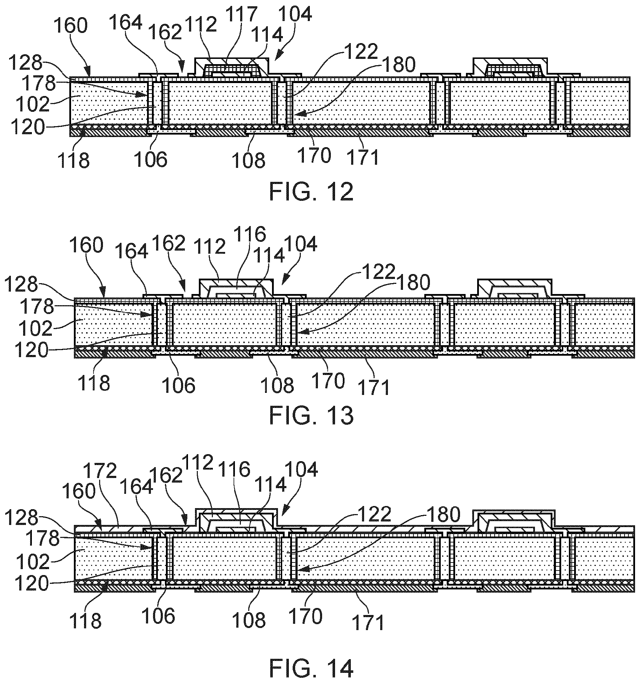

For the further steps in connection with Figures 12-14, reference is made to the previous explanations regarding Figures 6-8 in a similar manner.

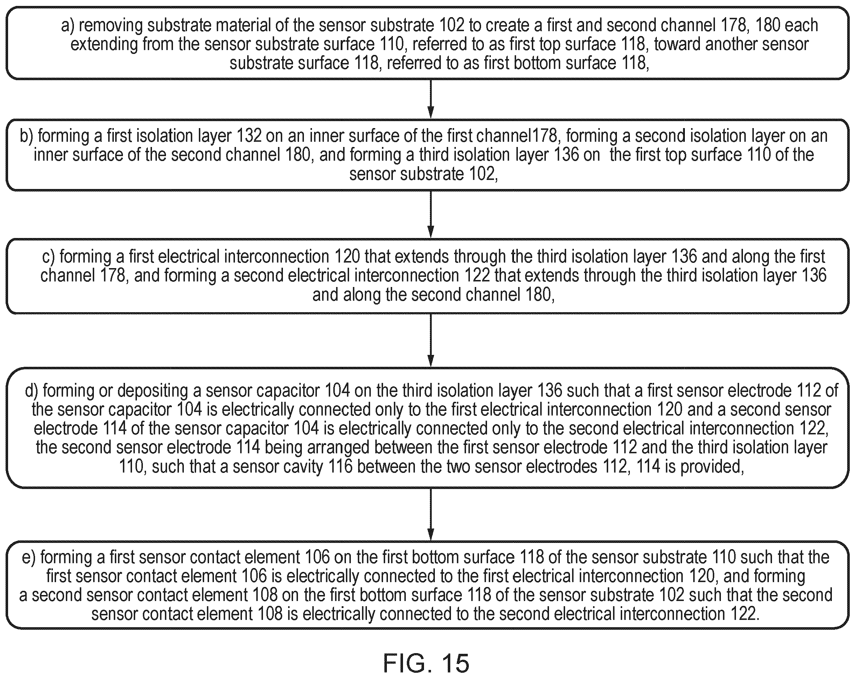

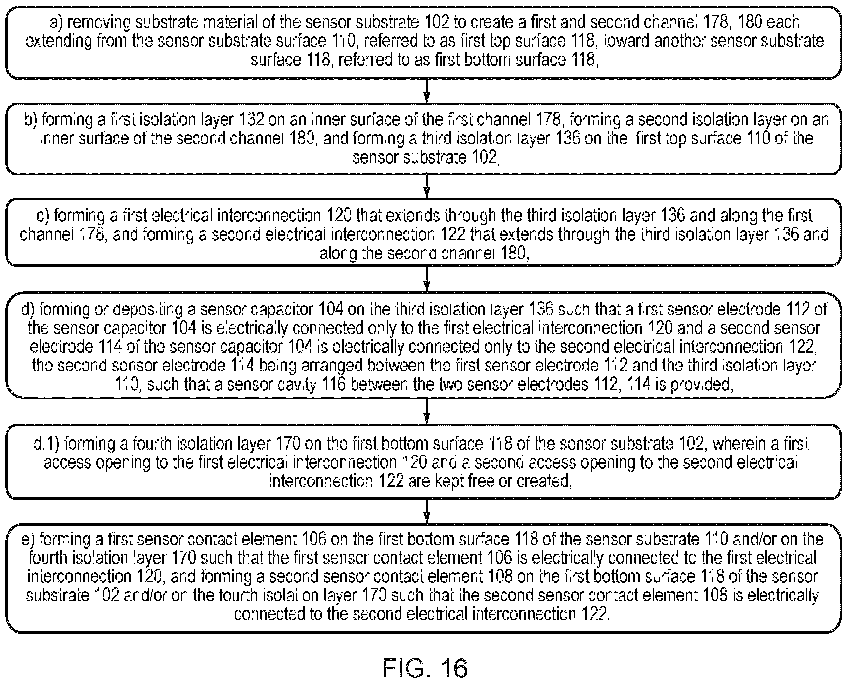

In Figures 15 and 16, flowcharts are schematically shown as examples of a method. For the methods, reference is made to the previous explanations, advantageous features, technical effects and advantages in a similar manner.

In the flow chart of Figure 15, process 156 may comprise the following steps:
a) removing substrate material of the sensor substrate 102 to create a first and second channel 178, 180 each extending from the sensor substrate surface 110, referred to as first top surface 110, toward another sensor substrate surface 118, referred to as first bottom surface 118,
b) forming a first isolation layer 132 on an inner surface of the first channel 178, forming a second isolation layer on an inner surface of the second channel 180, and forming a third isolation layer 136 on the first top surface 110 of the sensor substrate 102,
c) forming a first electrical interconnection 120 that extends through the third isolation layer 136 and along the first channel 178, and forming a second electrical interconnection 122 that extends through the third isolation layer 136 and along the second channel 180,
d) forming or depositing a sensor capacitor 104 on the third isolation layer 136 such that a first sensor electrode 112 of the sensor capacitor 104 is electrically connected only to the first electrical interconnection 120 and a second sensor electrode 114 of the sensor capacitor 104 is electrically connected only to the second electrical interconnection 122, the second sensor electrode 114 being arranged between the first sensor electrode 112 and the third isolation layer 136, such that a sensor cavity 116 between the two sensor electrodes 112, 114 is provided, and
e) forming a first sensor contact element 106 on the first bottom surface 118 of the sensor substrate 102 such that the first sensor contact element 106 is electrically connected to the first electrical interconnection 120, and forming a second sensor contact element 108 on the first bottom surface 118 of the sensor substrate 102 such that the second sensor contact element 108 is electrically connected to the second electrical interconnection 122.

In the flow chart of Figure 16, process 156 may additionally comprise the following step:
d.1) forming a fourth isolation layer 170 on the first bottom surface 118 of the sensor substrate 102, wherein a first access opening to the first electrical interconnection 120 and a second access opening to the second electrical interconnection 122 are kept free or created.

The first and second sensor contact elements 106, 108 may be arranged and/or disposed on the fourth isolation layer in step e). In an example, step d.1) may be performed between step d) and step e).

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. **In** different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. A sensor device comprising:
a sensor substrate,
a sensor capacitor,
a first sensor contact element, and
a second sensor contact element,
wherein the sensor capacitor is arranged on a surface, referred to as the first top surface, of the sensor substrate,
wherein the sensor capacitor comprises a first sensor electrode and a second sensor electrode,
wherein the second sensor electrode is arranged between the first sensor electrode and the first top surface of the sensor substrate such that a sensor cavity is provided between the first and second sensor electrodes,
wherein both of the first and second sensor contact elements are arranged on another surface, referred to as the first bottom surface, of the sensor substrate,
wherein a first electrical interconnection extends through the sensor substrate from the first sensor electrode to the first sensor contact element, and
wherein a second electrical interconnection extends through the sensor substrate from the second sensor electrode to the second sensor contact element.

2. The sensor device according to the preceding claim, wherein the second sensor electrode is disposed on the sensor substrate, wherein the first sensor electrode extends as a diaphragm over the second sensor electrode.

3. The sensor device according to any of the preceding claims, wherein the sensor cavity is formed between the first sensor electrode and the sensor substrate, such that the second sensor electrode is arranged in the sensor cavity.

4. The sensor device according to any of the preceding claims, wherein a working gas in the sensor cavity comprises a predefined reference pressure that is less than or equal to a predefined atmospheric pressure.

5. The sensor device according to any of the preceding claims, wherein the first electrical interconnection is electrically isolated from the sensor substrate by a first isolation, and wherein the second electrical interconnection is electrically isolated from the sensor substrate by a second isolation.

6. The sensor device according to the preceding claim, wherein the first isolation is a hollow cylindrical first isolation layer and the second isolation is a hollow cylindrical second isolation layer.

7. The sensor device according to any of the preceding claims, wherein the sensor capacitor is electrically isolated from the sensor substrate by a third isolation.

8. The sensor device according to the preceding claim, wherein the third isolation is a third isolation layer on the first top surface of the sensor substrate, wherein the sensor capacitor is attached to the sensor substrate via the third isolation layer.

9. The sensor device according to claim 7 or 8, if depending on claim 5 or 6, wherein the first, second and third isolations are contiguous.

10. A sensor system, comprising:
a sensor device according to any of the preceding claims,
a system substrate, and
a circuit,
wherein the circuit is arranged on a surface, referred to as a second top surface, of the system substrate,
wherein the circuit comprises a first circuit contact element and a second circuit contact element, and
wherein the first sensor contact element is electrically coupled to the first circuit contact element and the second sensor contact element is electrically coupled to the second circuit contact element such that the first bottom surface of the sensor substrate is arranged opposite the circuit and/or the system substrate.

11. The sensor system according to the preceding claim, wherein the circuit is an integrated circuit, IC.

12. The sensor system according to claim 10, wherein the sensor system comprises an integrated circuit, IC, being arranged on the system substrate, wherein the sensor contact elements are electrically coupled to the IC via the circuit.

13. A method of manufacturing a sensor device, the method comprising the steps of:
a) removing substrate material of a sensor substrate to create a first channel and a second channel each extending from a sensor substrate surface, referred to as first top surface, toward another sensor substrate surface, referred to as first bottom surface,
b) forming a first isolation layer on an inner surface of the first channel, forming a second isolation layer on an inner surface of the second channel, and forming a third isolation layer on the first top surface of the sensor substrate,
c) forming a first electrical interconnection that extends through the third isolation layer and along the first channel, and forming a second electrical interconnection that extends through the third isolation layer and along the second channel,
d) forming or depositing a sensor capacitor on the third isolation layer such that a first sensor electrode of the sensor capacitor is electrically connected only to the first electrical interconnection and a second sensor electrode of the sensor capacitor is electrically connected only to the second electrical interconnection, the second sensor electrode being arranged between the first sensor electrode and the third isolation layer, such that a sensor cavity is provided between the first sensor electrode and the second sensor electrode, and
e) forming a first sensor contact element on the first bottom surface of the sensor substrate such that the first sensor contact element is electrically connected to the first electrical interconnection, and forming a second sensor contact element on the first bottom surface of the sensor substrate such that the second sensor contact element is electrically connected to the second electrical interconnection.

14. The method according to the preceding claim,
wherein the first and second channels are each formed as a blind hole or a through hole in step a),
wherein the first isolation layer formed on the inner surface of the first channel in step b) forms a first sub-channel,
wherein the second isolation layer formed on the inner surface of the second channel in step b) forms a second sub-channel,
wherein the first electrical interconnection in step c) is formed by filling the first sub-channel with electrically conductive material,
wherein the second electrical interconnection in step c) is formed by filling the second sub-channel with electrically conductive material, and wherein substrate material is removed from the first bottom surface of the sensor substrate in step c) such that the first and second isolation layers are exposed.

15. The method according to claim 13,
wherein the first and second channels are each created as a hollow cylindrical channels in step a),
wherein the substrate material removed for the first channel in step a) is replaced by the first isolation layer in step b),
wherein the substrate material removed for the second channel in step a) is replaced by the second isolation layer in step b), and
wherein substrate material on the first bottom surface of the sensor substrate is removed in step c) such that the first and second isolation layers are exposed, wherein the substrate material encased by the first isolation layer forms the first electrical interconnection and wherein the substrate material encased by the second isolation layer forms the second electrical interconnection.
